# EUROPEAN PATENT SPECIFICATION

(11) **EP 3 732 756 B1**
(45) Date of publication and mention of the grant of the patent: **17.09.2025**
(21) Application number: 18896645.1
(22) Date of filing: 27.12.2018
(51) Int. Cl.: G01B 11/25, H01S 5/42, H01S 5/183, H01S 5/14, G06V 10/145

(54) **STRUCTURED LIGHT PROJECTION SYSTEM INCLUDING NARROW BEAM DIVERGENCE SEMICONDUCTOR SOURCES**
STRUKTURIERTES LICHTPROJEKTIONSSYSTEM MIT HALBLEITERQUELLEN MIT ENGER STRAHLENDIVERGENZ
SYSTÈME DE PROJECTION DE LUMIÈRE STRUCTURÉE COMPRENANT DES SOURCES SEMI-CONDUCTRICES À FAIBLE DIVERGENCE DE FAISCEAU

(30) Priority: 28.12.2017 US 201762611159 P
(43) Date of publication of application: 04.11.2020
(73) Proprietor: ams-OSRAM International GmbH, 93055 Regensburg (DE)
(72) Inventor: SEURIN, Jean-Francois, 5656 AE Eindhoven (NL); GHOSH, Chuni, 5656 AE Eindhoven (NL); VAN LEEUWEN, Robert, 5656 AE Eindhoven (NL)
(74) Representative: Viering, Jentschura & Partner mbB Patent- und Rechtsanwälte
(86) International application number: PCT/US2018/067593
(87) International publication number: WO 2019/133655

(56) References cited:
- EP-A2- 2 610 978
- US-A1- 2002 097 771
- US-A1- 2005 074 045
- US-A1- 2005 100 063
- US-A1- 2005 243 890
- US-A1- 2013 038 881
- US-A1- 2015 078 410
- US-A1- 2016 254 638

## Description

### FIELD OF THE DISCLOSURE

The present disclosure relates to narrow beam divergence semiconductor sources and their incorporation into structured light projection systems.

### BACKGROUND

Structured light projection systems can be used, for example, to obtain depth and surface information of objects in the scene. Such systems sometimes use light emitting devices such as vertical-cavity surface-emitting lasers (VCSELs). A vertical-cavity surface-emitting laser (VCSEL) is a semiconductor-based laser diode that can emit a highly efficient optical beam vertically, for example, from its top surface. In VCSELs, high reflectivity mirrors are generally required. The high reflectivity mirrors can be implemented, for example, as distributed Bragg reflectors (DBR) (e.g., quarter-wave-thick layers of alternating high and low refractive indexes), made of semiconductor or dielectric material. To achieve a high reflectivity with a reasonable number of layers, a high index contrast is provided (e.g., a high-contrast DBR). However, use of high-contrast DBR can generate a broad stop-band and, in the case of VCSELs with a long internal monolithic cavity, this will allow multiple longitudinal modes to lase. The longitudinal modes can, in some applications, give rise to undesirable or unstable operation (e.g., "kinks" in the power versus current curve; mode-hoping).

US2016254638 describes a miniature structured light illuminator which uses a semiconductor surface emitting array including VCSEL or RC-LED array and an array of microlens elements to generate a wide range of structured light illumination patterns.
US2002097771 describes a method comprising forming an optical cavity for an optical device and forming at least one reflector for the optical cavity for the optical device, the at least one reflector having at least two sections.

### SUMMARY

The invention is defined in the appended claims. We describe herein narrow beam divergence semiconductor sources and their integration into structured light projection systems.

For example, we describe herein, a structured light projector includes an array of narrow beam divergence semiconductor sources, each narrow beam divergence semiconductor source within the array being operable to generate a beam with a substantially narrow beam divergence and substantially uniform beam intensity. Multiple electrical contacts are operable to direct electric current to the array of narrow beam divergence semiconductor sources. A projection lens is operable to generate an image of the array of narrow beam divergence semiconductor source.

Each of the narrow beam divergence semiconductor sources can include an extended length mirror (also referred to sometimes as a hybrid mirror) that can help suppress one or more longitudinal and/or transverse modes such that the beam divergence and/or the spectral width of emission is substantially reduced.

Some implementations include one or more of the following features. For example, each narrow beam divergence semiconductor source can include an optical resonant cavity including a high reflection mirror having first and second sides, an extended length mirror having first and second sides, and an active region. The high reflection mirror and the extended length mirror can be disposed on distal sides of the active region such that the first side of the high reflection mirror is coupled to a first side of the active region and the first side of the extended length mirror is coupled to a second side of the active region opposing the first. Electrical contacts are operable to direct electric current to the active region. The extended length mirror and the high reflection mirror can be operable to suppress one or more longitudinal and/or transverse modes. In some implementations, only one longitudinal mode lases.

The array can include any of various types of narrow beam divergence semiconductor sources including, for example, VCSELs, VECSELs, LEDs and RC-LEDs, and edge-emitting lasers, such as those described in greater detail below.

Other aspects, features and various advantages will be readily apparent from the following detailed description, the accompanying drawings, and the claims.

### BRIEF DESCRIPTION OF THE DRAWINGS

FIG. 1 illustrates an example of a top-emitting VCSEL structure.
FIG. 2 illustrates another example of a top-emitting VCSEL structure.
FIG. 3 illustrates an example of a bottom-emitting VCSEL structure.
FIG. 4 illustrates an example of a VECSEL structure.
FIG. 5 illustrates an example of a LED structure.
FIG. 6 illustrates an example of a RC-LED structure.
FIG. 7 illustrates an example of an edge-emitting laser.
FIG. 8 illustrates an example of a structured light projection system.

### DETAILED DESCRIPTION

The present disclosure describes VCSELs having low divergence and/or operable for high single-mode power in some cases. In particular, a hybrid mirror is provided by combining a narrow bandwidth mirror with a high-reflectivity mirror, such that the narrow bandwidth mirror is placed within the laser cavity (i.e., between two high-reflectivity mirrors). Preferably, the narrow bandwidth mirror has a sufficiently large penetration depth to achieve the desired diffraction losses of higher order transverse modes, and has a narrow enough stop-band to filter out unwanted modes. The reflectivity of the high-reflectivity mirror should be insufficient by itself for the laser to achieve lasing. There should be an adequate phase matching layer between the two mirrors for constructive interference. The combined reflectivity at the designed wavelength (peak reflectivity) is sufficient for the laser to achieve lasing.

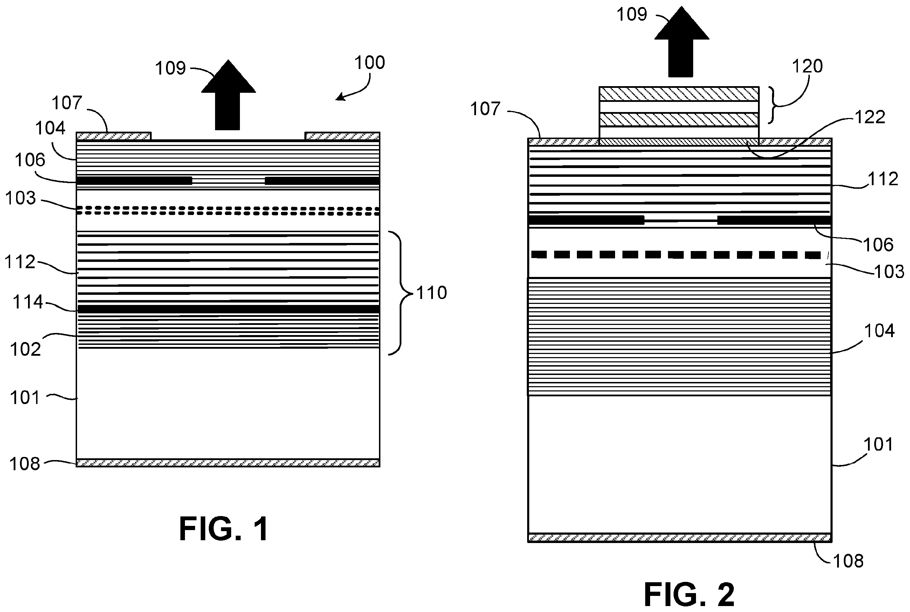

As shown in FIG. 1, a top-emitting VCSEL device 100 includes a substrate 101 (e.g., a N-GaAs substrate) on which epitaxial layers for the VCSEL structure are grown, for example, by a metal-organic chemical vapor deposition (MOCVD) or other deposition process. The optical resonant laser cavity of the VCSEL is formed by a hybrid mirror 110 and a distributed Bragg grating (DBR) partial-reflectivity top be achieved by combining a narrow bandwidth mirror 112 (e.g., a low-contrast N-DBR) with a high-reflectivity (e.g., 100%) bottom mirror 102, such that the narrow bandwidth mirror 112 is placed within the laser cavity (i.e., between the two relatively high-reflectivity mirrors 102, 104). The bottom mirror 102 can be implemented, for example, as a high-contrast N-DBR. One or more phase-matching layers 114 can be provided between the bottom mirror 102 and the narrow bandwidth mirror 112. The top mirror 104 can be implemented, for example, as a high-contrast P-DBR.

A gain section 103, which may be referred to as an active section and can include quantum wells, is disposed between the hybrid reflector 110 and the top reflector 104. A current aperture 106 confines the current in the center region of the VCSEL device 100 to activate the quantum wells to produce optical gain and to generate a laser cavity mode in the VCSEL laser cavity. In the top-emitting VCSEL device illustrated in FIG. 1, the output beam 109 is taken out of the partial-reflectivity top mirror 104.

The VCSEL device 100 is activated by applying current through an anode and cathode electrical connections 107, 108, which can be implemented, for example, as metal contacts. The presence of the low-contrast DBR in the hybrid mirror 110 increases the effective length of the optical resonant cavity such that multiple longitudinal modes are present. Thus, the hybrid mirror 110 also may be referred to as an extended length mirror. Because of the effective narrower bandwidth of the hybrid mirror 110, the additional, unwanted longitudinal modes have much higher round-trip losses compared to the main mode and, thus, the longitudinal modes do not achieve lasing. Thus, the hybrid mirror 110 and the high reflection mirror 104 are operable to provide mode filtering by suppressing one or more longitudinal and/or transverse modes. Preferably, in some implementations, only one longitudinal mode lases.

Various details of the hybrid mirror 110 can vary depending on the implementation. Nevertheless, in a particular example, the hybrid mirror 110 can be composed of the following layers: a low-contrast N-DBR layer 112 having a thickness in a range of 4 µm - 15 µm, and a refractive index difference Δn/n in the range of 1% - 7%; a N-phase matching layer 114 having a quarter wavelength optical thickness, and an index of refraction n of about 3.5; and a high-contrast N-DBR mirror 102 having a thickness in a range of 2 µm - 4 µm, and refractive index difference Δn/n in the range of 10% - 20%. Some or all of the foregoing values may differ for other implementations.

In some instances, the extended length mirror has an effective penetration depth extending multiple emission wavelength distances from the first side of the extended length mirror. For example, the effective penetration depth of the extended length mirror extends, in some cases, between 46 - 116 emission wavelength distances. In some cases, the penetration depth of the extended length mirror is between 6 - 15 µm, the emission wavelength is between 700 - 1064 nm, and the relative refractive index difference is between 1 - 7%. In some instances, the penetration depth of the high reflection mirror is between 2 - 4 µm, the emission wavelength is between 700 - 1064 nm, and the relative refractive index difference is between 10 -20%.

In some instances, the high reflection mirror has an effective penetration depth extending multiple emission wavelength distances from the first side of the high reflection mirror. In some cases, the effective penetration depth of the high reflection mirror extends between 15 - 30 emission wavelength distances

In some implementations, the full-width half-maximum (FWHM) intensity divergence angle is less than 10 degrees.

Some implementations include additional features to enhance operation. For example, as shown in FIG. 2, the VCSEL device includes a high-contrast dielectric mirror coating 120 on top of a phase matching layer122 and a low-contrast mirror 112.

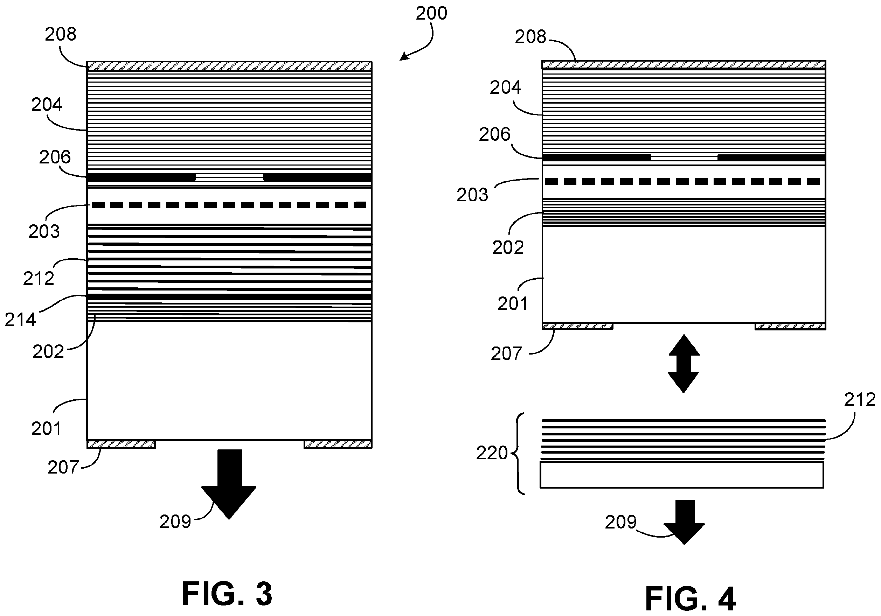

A hybrid mirror as described above also can be integrated into a bottom-emitting VCSEL 200 as shown in the example of FIG. 3. The VCSEL device 200 includes a substrate 201 (e.g., a N-GaAs substrate) on which epitaxial layers for the VCSEL structure are grown. The optical resonant laser cavity of the VCSEL is formed by a hybrid mirror 210 and a distributed Bragg grating (DBR) high-reflectivity top mirror 104 (e.g., 100%). The hybrid mirror 110 can be achieved by combining a narrow bandwidth mirror 212 (e.g., a low-contrast N-DBR) with the partial-reflectivity bottom mirror 202, such that the narrow bandwidth mirror 212 is placed within the laser cavity (i.e., between the two relatively high-reflectivity mirrors 202, 204). The bottom mirror 202 in this case is partially reflecting so as to allow for emission of the VCSEL beam 109. The bottom mirror 202 can be implemented, for example, as a high-contrast N-DBR. One or more phase-matching layers 214 can be provided between the bottom mirror 202 and the narrow bandwidth mirror 212. The top mirror 204 can be implemented, for example, as a high-contrast P-DBR.

The gain section 203, which can include quantum wells, is disposed between the hybrid mirror 210 and the top mirror 204. A current aperture 206 confines the current in the center region of the VCSEL device 200 to activate the quantum wells to produce optical gain and to generate a laser cavity mode in the VCSEL laser cavity. The VCSEL device 200 is activated by applying current through an anode and cathode electrical connections 207, 208, which can be implemented, for example, as metal contacts. In the bottom-emitting VCSEL device illustrated in FIG. 3, the output beam 209 is taken out of the partial-reflectivity bottom mirror 202.

As with the top-emitting VCSEL, the bottom-emitting VCSEL 200 is operable to provide mode filtering by suppressing one or more longitudinal and/or transverse modes. Preferably, in some implementations, only one longitudinal mode lases.

A low-contrast mirror can be used with other device such as vertical external-cavity surface-emitting lasers (VECSELs) as well, light emitting diodes (LEDs) and RC-LEDs. FIGS. 4-6 illustrate examples.

As shown in the example of FIG. 4, a low-contrast mirror 212 is provided on the external mirror 220 of a VECSEL. The low-contrast mirror 212 can be implemented, for example, using a shallow contrast dielectric coating.

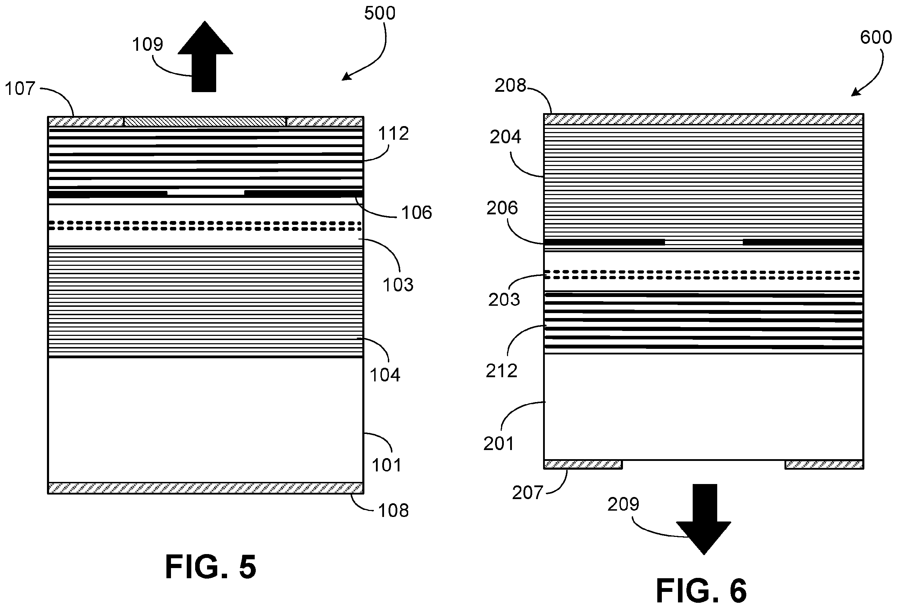

Similarly, FIG. 5 shows an example of a LED 500 that includes a low-contrast mirror 112, and FIG. 6 shows an example of a RC-LED 600 that includes a low-contrast mirror 212.

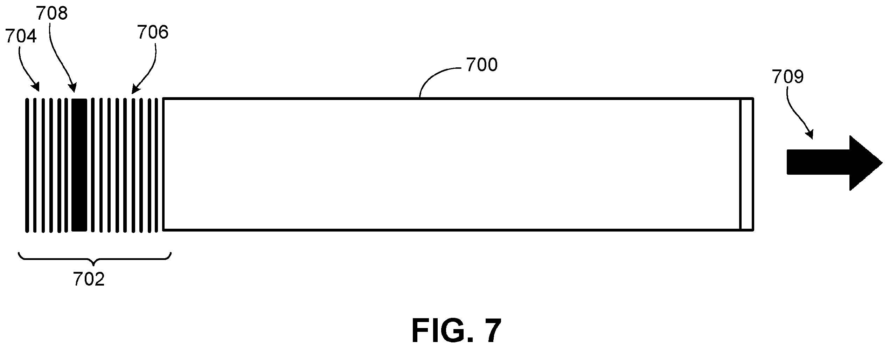

Although the foregoing examples illustrate incorporation of a low-contrast mirror 112 or 212 onto vertically emitting devices, the techniques also can be used in connection with edge-emitting devices (e.g., edge-emitting lasers). As illustrated in FIG. 7, a narrow beam divergence semiconductor optical edge-emitting laser 700 includes a hybrid mirror (e.g., a hybrid DBR) 702. The hybrid DBR has first and second sides, the edge-emitting laser 700 being disposed on the first side of the hybrid DBR 702. The hybrid DBR 702 includes a high-contrast region 704 and a low-contrast region 706. The high-contrast region 704 includes multiple high refractive index difference pairs of DBR materials of a second charge-carrier type, the high-contrast pairs being periodically disposed within the high-contrast region. The low-contrast region 706 includes multiple pairs of low refractive index difference DBR materials of the second charge-carrier type, the low-contrast pairs being periodically disposed within the low-contrast region. The hybrid DBR 702 can include one or more phase-matching layers 708 disposed between the high-contrast region 704 and the low-contrast region 706. The hybrid DBR also can include a backside dielectric coating disposed on the second side of the hybrid DBR. The hybrid DBR 702 and the edge-emitting laser 700 are operable in combination to generate a spectral bandwidth of emission 709, where one or more transverse and/or longitudinal modes are substantially suppressed such that the beam divergence and/or the spectral width of emission is substantially reduced.

The VCSELs and other light emitting devices described here can be used for applications such as compact, high-sensitivity LIDAR time-of-flight (TOF) systems and optical, high-bandwidth communications for high-speed data links. Examples of such applications include measuring short distances in self-driving automobiles and other proximity sensing applications. The devices also can be incorporated into three-dimensional sensing and gesture recognition, for example, in gaming and mobile devices. Further, in data-link applications, replacing low bandwidth data optoelectronics with higher bandwidth can enable existing fiber links to be upgraded at relatively low cost without the need to add fiber infrastructure.

In some applications, multiple narrow beam divergence semiconductor sources such as those described above can be integrated into an illumination system. For example, an array of narrow beam divergence semiconductor sources (e.g., VCSELs) as described above can be used for structured light projection in which a known optical pattern is projected onto a scene. Structured light projection systems can be used, for example, to obtain depth and surface information of objects in the scene.

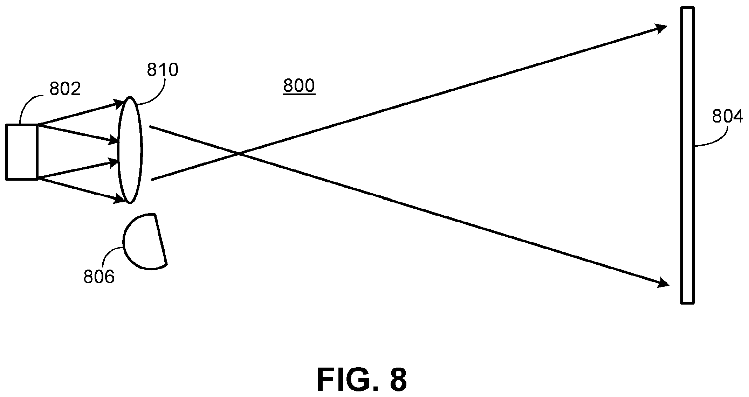

As shown in the example of FIG. 8, a structured light illumination system 800 includes an array 802 of VCSELs (such as those described in connection with any of FIGS. 1-3), and is operable to project an image composed of a structured light pattern 804. The projected pattern 804 can be used in conjunction with a camera 806 to capture three-dimensional (3D) images by analyzing the change or distortion in the structured light pattern by objects located at different distances.

In the example of FIG. 8, the VCSEL beams are emitted perpendicular to the VCSEL plane and, thus, the diameter of the projection lens 810 should be large enough to pass the VCSEL beams. If the beam has high divergence, then the lens diameter needs to be even larger to capture the entire beam. By reducing the VCSEL beam divergence, a smaller diameter lens 810 can be used in some cases. Smaller components can be important for producing miniature projectors for smart phones and other compact portable devices.

As the projected pattern 804 is used to capture 3D images, the depth of focus of the VCSEL image should be sufficiently large so that the pattern maintains its structure over a relatively long distance. The depth of focus depends on the beam divergence. If the beam divergence is large, the depth of focus will be short because adjacent spots in the pattern 804 will overlap at locations away from the focus position. For beams with low divergence, the distance before the beams overlap will be larger, thereby increasing the depth of focus.

The system 800 also includes multiple electrical contacts operable to direct electric current to the array 802 of narrow beam divergence semiconductor sources.

Although the foregoing example includes an array of VCSELs (e.g., as described in connection with any of FIGS. 1-3), the array may be composed of other types of narrow beam divergence semiconductor sources (e.g., VECSELs, LEDs, LC-LEDs, edge-emitting devices) as described above in connection with FIGS. 4, 5, 6, 7.

Various modifications can be made to the foregoing examples. Further, various features may be omitted in some implementations, while other features may be added. Features described in connection with different embodiments may, in appropriate instances, be combined in a single implementation. Thus, other implementations are within the scope of the claims.

## Claims

1. A structured light projector (800) comprising:
an array (802) of narrow beam divergence semiconductor sources, each narrow beam divergence semiconductor source (100) within the array being operable to generate a beam with a substantially narrow beam divergence and substantially uniform beam intensity wherein each narrow beam divergence semiconductor source within the array of sources includes:
an optical resonant cavity including a high reflection mirror (104) having first and second sides, an extended length mirror (110) having first and second sides, and an active region,
the high reflection mirror and the extended length mirror being disposed on distal sides of the active region such that the first side of the high reflection mirror is coupled to a first side of the active region, and the first side of the extended length mirror is coupled to a second side of the active region opposing the first, and the beam being having an emission wavelength; wherein the extended length mirror comprises a narrow bandwidth mirror (112) and a high-reflectivity mirror (102), the narrow bandwidth mirror (112) being placed between the high reflection mirror (104) and the high reflectivity mirror (102) and being implemented as a low-contrast N-Distributed Bragg Reflector and the high-reflectivity mirror (102) being implemented as a high- contrast N-Distributed Bragg Reflector;
a plurality of electrical contacts (107, 108) operable to direct electric current to the active region of each narrow beam divergence semiconductor sources in the array; and
a projection lens (810) operable to generate an image of the array of narrow beam divergence semiconductor source.

2. The structured light projector of Claim 1, wherein the extended length mirror and the high reflection mirror within each narrow beam divergence semiconductor source are operable to suppress one or more longitudinal
and/or transverse modes such that one or more longitudinal and/or transverse modes läse.

3. The structured light projector of any one of Claims 1 or 2, wherein the extended length mirrorwithin each narrow beam divergence semiconductor source has:
an effective penetration depth, the effective penetration depth extending a plurality of emission wavelength distances from the first side of the extended length mirror; and a relative refractive index difference.

4. The structured light projector of any one of the preceding Claims, wherein any one of the narrow beam divergence semiconductor sources are operable as any one of:
a VCSEL (100) ;
RC-LED (600);
an edge-emitting laser (700); and/or
an LED (500).

5. The structured light projector of any one of Claims 1 to 4, wherein the high reflection mirror of any of the narrow beam divergence semiconductor sources further include a supplemental extended length mirror with a first side substantially coincident with the first side of the high reflection mirror, the supplemental extended length mirror having an effective penetration depth, the effective penetration depth extending a plurality of emission wavelength distances from the first side of the supplemental extended length mirror, the supplemental extended length mirror having a relative refractive index difference.

6. The structured light projector of Claim 1, wherein the extended length mirror of any of the narrow beam divergence semiconductor sources comprises a narrow bandwidth mirror (112) and a high-reflectivity mirror (102) arranged to reduce the wavelength linewidth of the reflection such that one or more longitudinal and/or transverse modes are suppressed and one or more longitudinal and/or transverse modes lase.

7. The structured light projector of Claim 1, wherein the extended length mirror of any of the narrow beam divergence semiconductor sources comprises a hybrid DBR including a high-contrast region and a low-contrast region, wherein the high-contrast region includes a plurality of DBR pairs using materials with high refractive index difference, the DBR pairs being periodically disposed within the high-contrast region, and wherein the low- contrast region includes a plurality DBR pairs using materials with low refractive index difference, the low-contrast pairs being periodically disposed within the low-contrast region.

8. The structured light projector of Claim 1, wherein any of the narrow beam divergence semiconductor sources further includes an oxide aperture (106), the oxide aperture being operable to increase the current density in the active region; and/or wherein any of the narrow beam divergence semiconductor sources further includes an emission mirror and a backside mirror disposed on opposing sides of the narrow beam divergence semiconductor source, the backside mirror having higher reflectivity than the emission mirror.

9. The structured light projector of Claim 8, wherein:
the backside mirror includes the extended length mirror and the emission mirror includes the high reflection mirror; or
the backside mirror includes the high reflection mirror and the emission mirror includes the extended length mirror.

10. The structured light projector of Claim 7, wherein the DBR and/or the hybrid DBR of any of the narrow beam divergence semiconductor sources are operable, together with the plurality of electrical contacts, to direct electric current to the active region.

11. The structured light projector of Claim 7, wherein any of the narrow beam divergence semiconductor sources further include one or more phase- matching layers between the hybrid mirror components.

12. The structured light projector of Claim 7, wherein the high-contrast region of the hybrid DBR and the low-contrast region of the hybrid DBR of any of the narrow beam divergence semiconductor sources are interposed by a Substrate of a second charge-carrier type.

## Patentansprüche

1. Strukturierter Lichtprojektor (800), aufweisend:
ein Array (802) von Halbleiterquellen mit schmaler Strahldivergenz, wobei jede Halbleiterquelle (100) mit schmaler Strahldivergenz innerhalb des Arrays betreibbar ist, einen Strahl mit einer im Wesentlichen schmalen Strahldivergenz und einer im Wesentlichen gleichmäßigen Strahlintensität zu erzeugen, wobei jede Halbleiterquelle mit schmaler Strahldivergenz innerhalb des Arrays von Halbleiterquellen aufweist:
eine optische Resonanzkavität mit einem hochreflektierenden Spiegel (104) mit einer ersten Seite und einer zweiten Seite, einem verlängerten Spiegel (110) mit einer ersten Seite und einer zweiten Seite und einem aktiven Bereich,
wobei der hochreflektierende Spiegel und der verlängerte Spiegel auf distalen Seiten des aktiven Bereichs angeordnet sind, so dass die erste Seite des hochreflektierenden Spiegels mit einer ersten Seite des aktiven Bereichs gekoppelt ist und die erste Seite des verlängerten Spiegels mit einer der ersten Seite gegenüberliegenden zweiten Seite des aktiven Bereichs gekoppelt ist, und wobei der Strahl eine Emissionswellenlänge aufweist;
wobei der verlängerte Spiegel einen Spiegel mit schmaler Bandbreite (112) und einen Spiegel mit hoher Reflektivität (102) aufweist, wobei der Spiegel mit schmaler Bandbreite (112) zwischen dem hochreflektierenden Spiegel (104) und dem Spiegel mit hoher Reflektivität (102) angeordnet ist und als kontrastarmer N-Bragg-Spiegel ausgeführt ist und der Spiegel mit hoher Reflektivität (102) als kontrastreicher N-Bragg-Spiegel ausgeführt ist;
eine Vielzahl elektrischer Kontakte (107, 108), die dazu dienen, elektrischen Strom zu dem aktiven Bereich jeder Halbleiterquelle mit schmaler Strahldivergenz in dem Array zu leiten; und
eine Projektionslinse (810), die betreibbar ist, eine Abbildung des Arrays von Halbleiterquellen mit schmaler Strahldivergenz zu erzeugen.

2. Strukturierter Lichtprojektor nach Anspruch 1, wobei der verlängerte Spiegel und der hochreflektierende Spiegel innerhalb jeder Halbleiterquelle mit schmaler Strahldivergenz betreibbar sind, dass sie einen oder mehrere Längs- und/oder transversale Moden unterdrücken, so dass eine oder mehrere Längs- und/oder Transversalmoden lasen.

3. Strukturierter Lichtprojektor nach einem der Ansprüche 1 oder 2, der verlängerte Spiegel innerhalb jeder Halbleiterquelle mit schmaler Strahldivergenz aufweisend:
eine effektive Eindringtiefe, wobei sich die effektive Eindringtiefe über eine Vielzahl von Emissionswellenlängenabständen von der ersten Seite des verlängerten Spiegels erstreckt; und eine relative Brechungsindexdifferenz.

4. Strukturierter Lichtprojektor nach einem der vorstehenden Ansprüche, wobei jede der Halbleiterquellen mit schmaler Strahldivergenz als eine der folgenden Halbleiterquellen betreibbar ist:
ein VCSEL (100);
RC-LED (600);
ein kantenemittierender Laser (700); und/oder
eine LED (500).

5. Strukturierter Lichtprojektor nach einem der Ansprüche 1 bis 4, wobei der hochreflektierende Spiegel einer der Halbleiterquellen mit schmaler Strahldivergenz ferner einen zusätzlichen verlängerten Spiegel aufweist, dessen erste Seite im Wesentlichen mit der ersten Seite des Spiegels mit hoher Reflektivität zusammenfällt, wobei der zusätzliche verlängerte Spiegel eine effektive Eindringtiefe aufweist, wobei sich die effektive Eindringtiefe über eine Vielzahl von Emissionswellenlängenabständen von der ersten Seite des zusätzlichen Spiegels mit verlängerter Länge erstreckt, wobei der zusätzliche verlängerte Spiegel einen relative Brechungsindexdifferenz aufweist.

6. Strukturierter Lichtprojektor nach Anspruch 1, wobei der verlängerten Spiegel jeder der Halbleiterquellen mit schmaler Strahldivergenz einen Spiegel mit schmaler Bandbreite (112) und einen Spiegel mit hoher Reflektivität (102) aufweist, die so angeordnet sind, dass sie die Wellenlängenlinienbreite der Reflexion so reduzieren, dass ein oder mehrere Längs- und/oder Transversalmoden unterdrückt werden und ein oder mehrere Längs- und/oder Transversalmoden lasen.

7. Strukturierter Lichtprojektor nach Anspruch 1, wobei der verlängerte Spiegel einer der Halbleiterquellen mit schmaler Strahldivergenz einen Hybrid-DBR aufweist, der einen Bereich mit hohem Kontrast und einen Bereich mit niedrigem Kontrast aufweist, wobei der Bereich mit hohem Kontrast eine Vielzahl von DBR-Paaren aus Materialien mit hoher Brechungsindexdifferenz aufweist, wobei die DBR-Paare periodisch innerhalb des kontrastreichen Bereichs angeordnet sind, und wobei der kontrastarme Bereich eine Vielzahl von DBR-Paaren aus Materialien mit geringer Brechungsindexdifferenz aufweist, wobei die kontrastarmen Paare periodisch innerhalb des kontrastarmen Bereichs angeordnet sind.

8. Strukturierter Lichtprojektor nach Anspruch 1, wobei jede der Halbleiterquellen mit schmaler Strahldivergenz ferner eine Oxid-Apertur (106) aufweist, wobei die Oxid-Apertur betreibbar ist, die Stromdichte in dem aktiven Bereich zu erhöhen; und/oder
wobei jede der Halbleiterquellen mit schmaler Strahldivergenz ferner einen Emissionsspiegel und einen Rückseitenspiegel aufweist, die auf gegenüberliegenden Seiten der Halbleiterquelle mit schmaler Strahldivergenz angeordnet sind, wobei der Rückseitenspiegel eine höhere Reflektivität als der Emissionsspiegel aufweist.

9. Strukturierter Lichtprojektor nach Anspruch 8, wobei:
der Rückseitenspiegel den verlängerten Spiegel aufweist und der Emissionsspiegel den Spiegel mit hoher Reflektion aufweist; oder
der Rückseitenspiegel den Spiegel mit hoher Reflektion aufweist und der Emissionsspiegel den verlängerten Spiegel aufweist.

10. Strukturierter Lichtprojektor nach Anspruch 7, wobei der DBR und/oder der Hybrid-DBR einer der Halbleiterquellen mit schmaler Strahldivergenz zusammen mit der Vielzahl elektrischer Kontakte betreibbar sind, um elektrischen Strom zum aktiven Bereich zu leiten.

11. Strukturierter Lichtprojektor nach Anspruch 7, wobei jede der Halbleiterquellen mit schmaler Strahldivergenz ferner eine oder mehrere Phasenanpassungsschichten zwischen den Hybrid-Spiegel-Komponenten aufweist.

12. Strukturierter Lichtprojektor nach Anspruch 7, wobei der kontrastreiche Bereich des Hybrid-DBRs und der kontrastarme Bereich des Hybrid-DBRs einer beliebigen der Halbleiterquellen mit schmaler Strahldivergenz durch ein Substrat eines zweiten Ladungsträgertyps voneinander separiert sind.

## Revendications

1. Projecteur de lumière structurée (800), comprenant :
un réseau (802) de sources à semi-conducteur à divergence de faisceau étroite, chaque source à semi-conducteur à divergence de faisceau étroite (100) dans le réseau pouvant fonctionner pour générer un faisceau avec une divergence de faisceau sensiblement étroite et une intensité de faisceau sensiblement uniforme, dans lequel chaque source à semi-conducteur à divergence de faisceau étroite dans le réseau de sources comprend :
une cavité optique résonnante comprenant un miroir à réflexion élevée (104) ayant des premier et deuxième côtés, un miroir allongé (110) ayant des premier et deuxième côtés, et une région active,
le miroir à réflexion élevée et le miroir allongé étant disposés sur des côtés distaux de la région active de telle sorte que le premier côté du miroir à réflexion élevée soit couplé à un premier côté de la région active, et le premier côté du miroir allongé soit couplé à un deuxième côté de la région active opposé au premier, et le faisceau ayant une longueur d'onde d'émission ; dans lequel le miroir allongé comprend un miroir à bande passante étroite (112) et un miroir à réflectivité élevée (102), le miroir à bande passante étroite (112) étant placé entre le miroir à réflexion élevée (104) et le miroir à réflectivité élevée (102) et étant mis en œuvre comme un réflecteur de Bragg distribué N à faible contraste, et le miroir à réflectivité élevée (102) étant mis en œuvre comme un réflecteur de Bragg distribué N à contraste élevé ;
une pluralité de contacts électriques (107, 108) pouvant fonctionner pour diriger le courant électrique vers la région active de chaque source à semi-conducteur à divergence de faisceau étroite dans le réseau ; et
une lentille de projection (810) pouvant fonctionner pour générer une image du réseau de sources à semi-conducteur à divergence de faisceau étroite.

2. Projecteur de lumière structurée selon la revendication 1, dans lequel le miroir allongé et le miroir à réflexion élevée à l'intérieur de chaque source à semi-conducteur à divergence de faisceau étroite peuvent fonctionner pour supprimer un ou plusieurs modes longitudinaux et/ou transversaux de telle sorte qu'un ou plusieurs modes longitudinaux et/ou transversaux lasent.

3. Projecteur de lumière structurée selon l'une quelconque des revendications 1 ou 2, dans lequel le miroir allongé à l'intérieur de chaque source à semi-conducteur à divergence de faisceau étroite présente :
une profondeur de pénétration effective, la profondeur de pénétration effective s'étendant sur une pluralité de distances de longueur d'onde d'émission à partir du premier côté du miroir allongé ; et une différence d'indice de réfraction relative.

4. Projecteur de lumière structurée selon l'une quelconque des revendications précédentes, dans lequel l'une quelconque des sources à semi-conducteur à divergence de faisceau étroite peut fonctionner comme l'un quelconque des éléments suivants :
un VCSEL (100) ;
une RC-LED (600) ;
un laser à émission latérale (700) ; et/ou
une LED (500).

5. Projecteur de lumière structurée selon l'une quelconque des revendications 1 à 4, dans lequel le miroir à réflexion élevée de l'une quelconque des sources à semi-conducteur à divergence de faisceau étroite comprend en outre un miroir allongé supplémentaire dont un premier côté coïncide sensiblement avec le premier côté du miroir à réflexion élevée, le miroir allongé supplémentaire ayant une profondeur de pénétration effective, la profondeur de pénétration effective s'étendant sur une pluralité de distances de longueur d'onde d'émission à partir du premier côté du miroir supplémentaire allongé, le miroir supplémentaire allongé ayant une différence d'indice de réfraction relative.

6. Projecteur de lumière structurée selon la revendication 1, dans lequel le miroir allongé de l'une quelconque des sources à semi-conducteur à divergence de faisceau étroite comprend un miroir à bande passante étroite (112) et un miroir à réflectivité élevée (102) agencés pour réduire la largeur de raie de longueur d'onde de la réflexion de telle sorte qu'un ou plusieurs modes longitudinaux et/ou transversaux soient supprimés et qu'un ou plusieurs modes longitudinaux et/ou transversaux lasent.

7. Projecteur de lumière structurée selon la revendication 1, dans lequel le miroir allongé de l'une quelconque des sources à semi-conducteur à divergence de faisceau étroite comprend un DBR hybride comprenant une région à contraste élevé et une région à faible contraste, dans lequel la région à contraste élevé comprend une pluralité de paires de DBR utilisant des matériaux à différence d'indice de réfraction élevée, les paires de DBR étant disposées périodiquement dans la région à contraste élevé, et dans lequel la région à faible contraste comprend une pluralité de paires de DBR utilisant des matériaux à faible différence d'indice de réfraction, les paires à faible contraste étant disposées périodiquement dans la région à faible contraste.

8. Projecteur de lumière structurée selon la revendication 1, dans lequel l'une quelconque des sources à semi-conducteur à divergence de faisceau étroite comprend en outre une ouverture en oxyde (106), l'ouverture en oxyde pouvant fonctionner pour augmenter la densité de courant dans la région active ; et/ou dans lequel l'une quelconque des sources à semi-conducteur à divergence de faisceau étroite comprend en outre un miroir d'émission et un miroir arrière disposés sur des côtés opposés de la source à semi-conducteur à divergence de faisceau étroite, le miroir arrière ayant une réflectivité supérieure à celle du miroir d'émission.

9. Projecteur de lumière structurée selon la revendication 8, dans lequel :
le miroir arrière comprend le miroir allongé et le miroir d'émission comprend le miroir à réflexion élevée ; ou
le miroir arrière comprend le miroir à réflexion élevée et le miroir d'émission comprend le miroir allongé.

10. Projecteur de lumière structurée selon la revendication 7, dans lequel le DBR et/ou le DBR hybride de l'une quelconque des sources à semi-conducteur à divergence de faisceau étroite peuvent fonctionner, conjointement avec la pluralité de contacts électriques, pour diriger le courant électrique vers la région active.

11. Projecteur de lumière structurée selon la revendication 7, dans lequel l'une quelconque des sources à semi-conducteur à divergence de faisceau étroite comprend en outre une ou plusieurs couches d'adaptation de phase entre les composants de miroir hybride.

12. Projecteur de lumière structurée selon la revendication 7, dans lequel la région à contraste élevé du DBR hybride et la région à faible contraste du DBR hybride de l'une quelconque des sources à semi-conducteur à divergence de faisceau étroite sont interposées par un substrat d'un deuxième type de porteur de charge.
